# EUROPEAN PATENT APPLICATION

(11) **EP 0 877 481 A2**
(43) Date of publication of application: **11.11.1998**
(21) Application number: 97310156.1
(22) Date of filing: 16.12.1997
(51) Int. Cl.: H03H 11/04

(54) **Transconductance variable method and circuit, and variable bandwidth filter and variable gain amplifier using same**

(30) Priority: 09.05.1997 KR 9717845
(71) Applicant: Samsung Electronics Co., Ltd., Suwon City, Kyungki-do (KR)
(72) Inventor: Cho, Gea-Ok c/o Samsung Electronics Co. Ltd., Suwon-city, Kyungki-do 442-742 (KR); Kim, Cheon-Sup, Suwon-city, Kyungki-do (KR)
(74) Representative: Chugg, David John

(57) **Abstract**

A transconductance variable method and circuit, and a filter and an amplifier using the same. An output transconductance is set by selectively adding at least two transconductances (100, 102) which are identically set according to a select signal for variably selecting the output conductance.

## Description

The present invention relates to a transconductor and, more particularly, to a transconductance variable method and circuit, and a filter and an amplifier using the same.

Recently, an optical disk reproducing apparatus for reproducing a signal from a disk, such as a compact disk (CD), a digital video disk (DVD), etc., has shown a tendency toward a high reproducing speed. In the optical disk reproducing apparatus of a low reproducing speed, such as normal, double, quadruple or octuple speed, since a frequency of an input signal picked up from the disk is low, there is no need to use an equalizer. However, in the optical disk reproducing apparatus of a high reproducing speed, the frequency characteristic is very important. Especially, as the reproducing speed increases, the frequency of the input signal becomes high. However, since a level of the input signal picked up from the disk becomes low at a high frequency, it is necessary to additionally install an equalizer for boosting the high frequency. In the optical disk reproducing apparatus of a DVD type, a signal received at a pickup has different levels according to frequencies and these levels depend on the kind of the disk and the kind of the pickup. In order to appropriately process the input signal, the equalizer of high performance should be used.

Since there are many kinds of pickups and disks used in the optical disk reproducing apparatus, the frequency characteristic of the equalizer, i.e., the frequency characteristic of a filter utilized in the equalizer should be correspondingly set according to the kind of the disk and the kind of the pickup. However, if each frequency characteristic corresponding to the kind of the disk and the kind of the pickup used in the optical disk reproducing apparatus is set by additional filters and if one filter is selectively used as the need arises, the construction of the equalizer is complicated and the stability thereof is degraded.

Meanwhile, a transconductor generates an output current which is proportional to an input signal voltage. Assuming that the input signal voltage is Vin and the output current is i, the output current $\text{i = gm × Vin}$ (where gm is a transconductance of the transconductor). If a capacitor is connected to the output of the transconductor, the characteristic of an output signal voltage Vo for the input signal voltage Vin can be expressed as follows: $\text{Vo/Vin = gm × (1/sC)}$ (where C is a capacitance of the capacitor and s is the Laplace variable). The combination of the transconductor and the capacitor can be used in the filter. The characteristic of such a filter is represented by gm × C. The transconductor is also used in an amplifier.

If the filter using the combination of the transconductor and the capacitor is utilized in the equalizer of the optical disk reproducing apparatus, the frequency characteristic may vary according to the transconductance. Therefore, the frequency characteristic corresponding to the kind of the disk and the kind of the pickup can be set by additional filters if only the transconductances of the filters are different, that is, if only the transconductors having different output transconductances are used in the filters.

If the transconductance varies whenever the kind of the disk and the kind of the pickup become different, the frequency characteristic of the filter can be variably set even if only one filter is used. To variably set the frequency characteristic of the filter simply and stably, there is needed a technique for simply and stably varying the transconductance. Such a technique is applicable to the variable setting of a gain of the amplifier.

As described above, there has been demanded a technique for variably setting the frequency characteristic of the filter or the gain of the amplifier simply and stably. To this, a technique for simply and stably varying the transconductance of the transconductor has been demanded.

It is an aim of embodiments of the invention to provide a method and circuit which can simply and stably vary a transconductance.

It is another aim of embodiments of the invention to provide a variable bandwidth filter which can variably set a frequency characteristic simply and stably.

It is still another aim of embodiments of the invention to provide a variable gain amplifier which can variably set its gain.

According to the present invention, an output transconductance is set by selectively adding at least two transconductances which are identically set according to a select signal for variably selecting the output conductance.

According to a first aspect of the present invention, there is provided a transconductance variable method comprising the step of: setting an output transconductance by selectively adding at least two transconductances which are identically set according to a select signal for variably selecting said output conductance.

According to a second aspect of the invention, there is provided a transconductance variable circuit comprising: at least two transconductance cells each having a commonly connected output terminal, for generating a current which is proportional to an input signal voltage V_{IN} according to transconductances which are identically set; and at least one select circuit connected to a corresponding transconductance cell, for selectively operating said corresponding transconductance cell according to a select signal for variably selecting a transconductance appearing at said output terminal.

Preferably, each of said transconductance cells comprises: a current source I_{S} for supplying a constant current; and a first MOS (Metal Oxide Semiconductor) transistor M1 connected between said current source I_{S} and a ground terminal, for receiving said input signal voltage V_{IN} through its gate electrode.

Preferably, said select circuit comprises: a first switch for switching on or off a supply path of a current bias to the current source of said corresponding transconductance cell according to said select signal; and a second switch for switching on or off a supply path of said input signal voltage V_{IN} to the gate electrode of said first MOS transistor M1 of said corresponding transconductance cell according to said select signal, said second switch being interlocked with said first switch.

Each of said transconductance cells may further comprise a second MOS transistor M2 connected between said current source I_{S} and said first MOS transistor M1, for receiving a bias voltage V_{b} for tuning an output transconductance through its gate electrode.

According to a third aspect of the invention, there is provided a variable bandwidth filter comprising: at least two transconductance cells each having a commonly connected output terminal, for generating a current which is proportional to an input signal voltage V_{IN} according to transconductances which are identically set; an operational amplifier having an inverting input terminal connected to the output terminal of said transconductance cells; a capacitor (C1) connected between said inverting input terminal and an output terminal of said operational amplifier; and at least one select circuit connected to a corresponding transconductance cell, for setting a frequency characteristic by selectively operating said corresponding transconductance cell according to a select signal for variably selecting said frequency characteristic.

According to a fourth aspect of the present invention, there is provided a variable gain amplifier comprising: at least two transconductance cells each having a commonly connected output terminal, for generating a current which is proportional to an input signal voltage V_{IN} according to transconductances which are identically set; an operational amplifier having an inverting input terminal connected to the output terminal of said transconductance cells; a resistor (R1) connected between said inverting input terminal and an output terminal of said operational amplifier; and at least one select circuit connected to a corresponding transconductance cell, for setting a gain by selectively operating said corresponding transconductance cell according to a select signal for variably selecting said gain.

Preferably, in said amplifier or said filter, said transconductance cell comprises: a current source I_{S} connected between a power terminal and said output terminal; and a first MOS (Metal Oxide Semiconductor) transistor M1 connected between said output terminal and a ground terminal, for receiving said input signal voltage though its gate electrode.

Said select circuit of said amplifier or said filter may comprise: a first switch for switching on or off a supply path of a current bias I_{b} to the current source I_{S} of said corresponding transconductance cell according to said select signal; and a second switch for switching on or off a supply path of said input signal voltage V_{IN} to the gate electrode of said first MOS transistor M1 of said corresponding transconductance cell according to said select signal, said second switch being interlocked with said first switch.

In the variable bandwidth filter, each of said transconductance cells preferably further comprises a second MOS transistor M2 connected between said current source I_{S} and said first MOS transistor M1, for receiving a bias voltage V_{b} for tuning said frequency characteristic through its gate electrode.

In the variable gain amplifier, each of said transconductance cells preferably further comprises a second MOS transistor M2 connected between said current source I_{S} and said first MOS transistor M1, for receiving a bias voltage for tuning said gain through its gate electrode.

For a better understanding of the invention, and to show how embodiments of the same may be carried into effect, reference will now be made, by way of example, to the accompanying diagrammatic drawings, in which:
Figure 1 illustrates a transconductance variable circuit according to an aspect of the present invention;
Figure 2 illustrates a variable bandwidth filter according to another aspect of the present invention;
Figure 3 illustrates frequency characteristics when the transconductance variable circuit of Figure 1 is applied to an equalizer of an optical disk reproducing apparatus; and
Figure 4 illustrates a variable gain amplifier according to an aspect of the present invention.

In the following description, numerous specific details, such as circuit constructions, elements, etc., are set forth to provide a more thorough understanding of the present invention. It will be apparent, however, to one skilled in the art, that the present invention may be practised without these specific details. In other instances, well known features and constructions are not described in detail so as not to obscure the present invention.

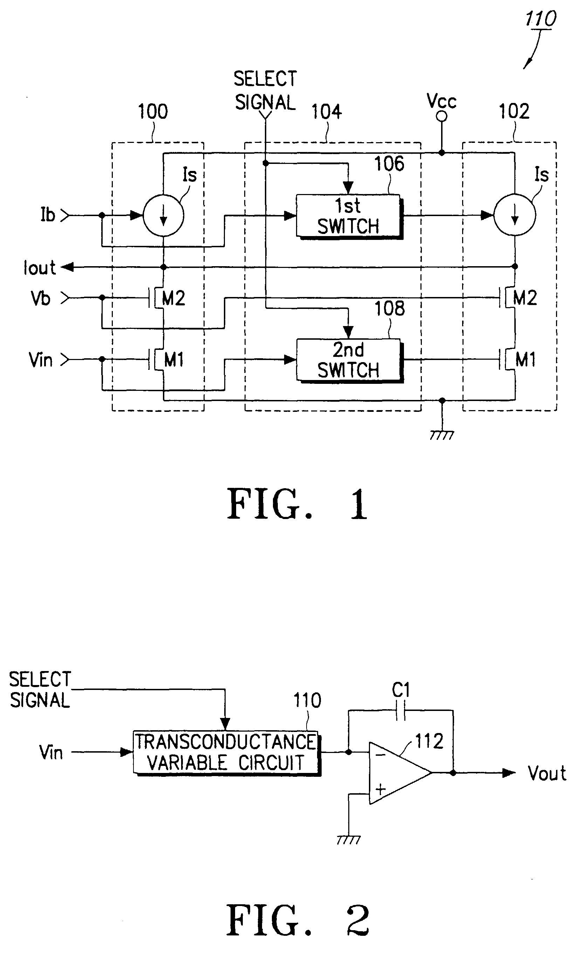

Figure 1 illustrates a transconductance variable circuit 110 for variably selecting one of two transconductances. The transconductance variable circuit 110 of Figure 1 includes first and second transconductance cells 100 and 102 and a select circuit 104. The two transconductance cells 100 and 102 have the same construction and generate the same output transconductance.

Output terminals of the first and second transconductance cells 100 and 102 are commonly connected to each other. An input signal voltage Vin, a current bias Ib and a bias voltage Vb are directly applied to the first transconductance cell 100. Although the bias voltage Vb is also directly applied to the second transconductance cell 102, the input signal voltage Vin and the current bias Ib are selectively applied to the second transconductance cell 102 by the select circuit 104. Each of the first and second transconductance cells 100 and 102 has one current source Is and two MOS (Metal Oxide Semiconductor) transistors M1 and M2. The current source Is is connected between a power voltage Vcc and the output terminal. The MOS transistors M1 and M2 are serially connected between the output terminal and a ground terminal. The input signal voltage Vin is applied to the gate electrode of the MOS transistor M1, and the bias voltage Vb is applied to the gate electrode of the MOS transistor M2. The voltage Vin is the input signal voltage of an apparatus to which the transconductance variable circuit of Figure 1 is applied, that is, the input signal voltage of a filter or an amplifier. The current bias Ib sets the current of the current source Is. The bias voltage Vb is a voltage for tuning an output transconductance of each of the first and second transconductance cells 100 and 102.

If the input signal voltage Vin is applied to the first transconductance cell 100 under the state that the current bias Ib and the bias voltage Vb are applied, the first transconductance cell 100 generates a current which is proportional to the input signal voltage Vin according to a setting transconductance. Similarly, if the input signal voltage Vin is applied to the second transconductance cell 102 under the state that the current bias Ib is applied though the select circuit 104 and the bias voltage Vb are applied, the second transconductance cell 102 generates a current which is proportional to the input signal voltage Vin according to the setting transconductance.

The select circuit 104 having first and second switches 106 and 108 is correspondingly connected to the second transconductance cell 102 and selectively operates the second transconductance cell 102 according to a select signal. The first switch 106 switches on or off a supply path of the current bias Ib to the current source Is of the second transconductance cell 102 according to the select signal. The second switch 108 interlocked with the first switch 106 switches on or off a supply path of the input signal voltage Vin to the gate electrode of the MOS transistor M1 of the second transconductance cell 102 according to the select signal. The select signal is a signal for selecting one of two variable output transconductances. The select signal is applied as one form of logic "0" and "1". The first and second switches 106 and 108 are switched on or off by the select signal. For example, if the select signal of logic "0" is applied, the first and second switches 106 and 108 are switched on, and if the select signal of logic "1", they are switched off.

If the first and second switches 106 and 108 are switched off by the select signal, the current bias Ib and the input signal voltage Vin are not applied to the second transconductance cell 102. Therefore, only the first transconductance cell 100 out of the two transconductance cells 100 and 102 is operated. In this case, an output current Iout depends on the transconductance of the first transconductance cell 100. If both the first and second switches 106 and 108 are switched on, the current bias Ib and the input signal voltage Vin are applied to the second transconductance cell 102 as well as the first transconductance cell 100. Therefore, the first and second transconductance cells 100 and 102 are all operated. Since the output terminals of the transconductance cells 100 and 102 are commonly connected to each other, the output current Iout is a sum of the transconductances of the first and second transconductance cells 100 and 102. If the transconductance of each of the first and second transconductance cells 100 and 102 is gm, the output transconductance is 2gm. If the output current of each of the first and second transconductance cells 100 and 102 is Io, the final output current Iout is 2Io.

Consequently, the output transconductance can be variably set to one of two values by current switching for selectively operating the second transconductance cell 102 by the select circuit 104. In this case, the output transconductance can be simply varied by changing only the state of the select signal and stably varied by the current switching. Moreover, the characteristic of the transconductance cell can be accurately tuned by the bias voltage Vb applied to the MOS transistor M2. That is, since the current is adjusted by controlling the bias voltage Vb, the necessary output transconductance can be accurately tuned.

In order to set the transconductance to a plurality of variable values instead of two values, the second transconductance cell 102 and the select circuit 104 are additionally installed by the number of necessary steps. The number of select signals corresponds to the number of the added select circuits. For example, if the transconductance is set to 4 variable values, a pair of the transconductance cells and a pair of select circuits are additionally connected.

Figure 2 illustrates a variable bandwidth filter according to the teachings of the present invention. In Figure 2, the transconductance variable circuit of Figure 1 is applied to a low pass filter. The output current Iout shown in Figure 1 is supplied to an inverting input terminal (-) of an operational amplifier 112. A noninverting input terminal (+) of the operational amplifier 112 is grounded. A capacitor C1 is connected between the inverting input terminal (-) and an output terminal of the operational amplifier 112. The transconductance variable circuit 110 has the output transconductance varying according to the select signal. Since the transconductance is variably set according to the select signal, the select signal becomes a signal for variably selecting the frequency characteristic of the low pass filter.

The frequency characteristic of the low pass filter shown in Figure 2 is determined by the output transconductance of the transconductance variable circuit 110 and the capacitance of the capacitor C1. In this case, since the capacitance of the capacitor C1 is a fixed value and the transconductance is varied by the select signal, the frequency characteristic, that is, a cutoff frequency band, of the low pass filter is variable. Moreover, the frequency characteristic can be more accurately tuned by the bias voltage Vb applied to the MOS transistor M2. In other words, since the current is adjusted by controlling the bias voltage Vb, the frequency characteristic can be accurately tuned. According to an experimental result of the present invention, the variable range for the frequency characteristic obtained by controlling the bias voltage Vb shows about ±50% when the low pass filter is applied to the DVD of normal or double reproducing speed.

Therefore, if the low pass filter of Figure 2 is applied to the equalizer of the optical disk reproducing apparatus, the frequency characteristic can be variably set according to the kind of the currently reproduced disk. By using the transconductance variable circuit 110, the frequency characteristic of the filter is variably set simply and stably. Hence, if the present invention is applied to the equalizer of the optical disk reproducing apparatus, since the frequency characteristic can vary according to the characteristic difference of the disk and pickup, the distortion of a signal is minimized. Further, since the frequency characteristic is simply set by the current switching, it is possible to easily design the equalizer and to correspond to a high frequency. Hence, the present invention can be efficiently applied to the optical disk reproducing apparatus showing a tendency toward the high reproducing speed.

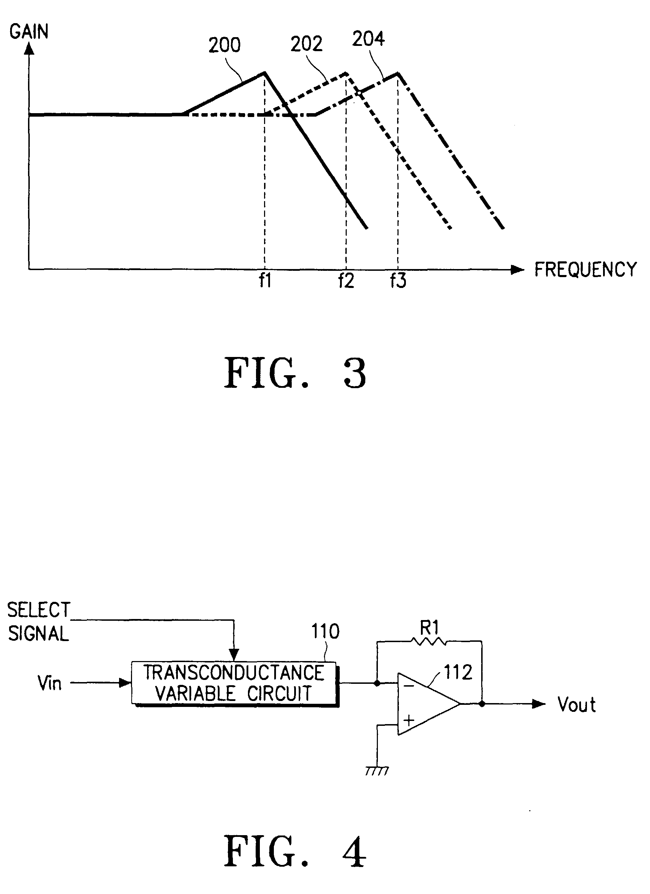

Figure 3 illustrates frequency characteristics when the transconductance variable circuit 110 is applied to the equalizer of the optical disk reproducing apparatus. Reference numbers 200, 202 and 204 show the variable setting of frequency characteristics for boosting the input signal when the DVD is normal speed, double speed and quadruple speed, respectively.

Figure 4 illustrates a variable gain amplifier according to the teachings of the present invention. In Figure 4, the transconductance variable circuit 110 of Figure 1 is applied to the amplifier. The output current Iout shown in Figure 1 is supplied to the inverting input terminal (-) of the operational amplifier 112. The noninverting input terminal (+) of the operational amplifier 112 is grounded. A resistor R1 is connected between the inverting input terminal (-) and the output terminal of the operational amplifier 112. The transconductance variable circuit 110 has the output transconductance varying according to the select signal. Since the transconductance is variably set according to the select signal, the select signal is a signal for variably selecting the gain of the amplifier.

The gain characteristic of the variable gain amplifier of Figure 4 is determined by the output transconductance of the transconductance variable circuit 110 and the resistance of the resistor R1. In this case, since the resistance of the resistor R1 is fixed and the transconductance is varied by the select signal, the gain of the variable gain amplifier is variable. The gain of the amplifier can be more accurately tuned by the bias voltage Vb applied to the MOS transistor M2. That is, since the current is adjusted by controlling the bias voltage Vb, the gain can be accurately tuned.

Since the gain of the amplifier is simply and stably set by the transconductance variable circuit 110, the present invention may be efficiently applied to an apparatus requiring a gain variation.

As noted previously, embodiments of the present invention can variably set the transconductance and the frequency characteristic of the filter simply and stably. Therefore, the present invention may be efficiently applied to the optical disk reproducing apparatus. Moreover, the gain of the amplifier can be variably set simply and stably.

While there is shown and described a preferred embodiment of the invention, it will be apparent to those skilled in the art that various changes and modifications may be made therein without departing from the scope of the invention as defined in the appended claims and that it may be possible, for example, to variably set the transconductance to a plurality of values.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A transconductance variable method comprising the step of:
setting an output transconductance by selectively adding at least two transconductances which are identically set according to a select signal for variably selecting said output conductance.

2. A transconductance variable circuit comprising:
at least two transconductance cells (100, 102) each having a commonly connected output terminal, for generating a current which is proportional to an input signal voltage V_{IN} according to transconductances which are identically set; and
at least one select circuit (104) connected to a corresponding transconductance cell, for selectively operating said corresponding transconductance cell according to a select signal for variably selecting a transconductance appearing at said output terminal.

3. The transconductance variable circuit as claimed in claim 2, wherein each of said transconductance cells (100, 102) comprises:
a current source I_{S} for supplying a constant current; and
a first MOS (Metal Oxide Semiconductor) transistor M1 connected between said current source I_{S} and a ground terminal, for receiving said input signal voltage V_{IN} through its gate electrode.

4. The transconductance variable circuit as claimed in claim 3, wherein said select circuit (104) comprises:
a first switch (106) for switching on or off a supply path of a current bias to the current source of said corresponding transconductance cell (102) according to said select signal; and
a second switch (108) for switching on or off a supply path of said input signal voltage V_{IN} to the gate electrode of said first MOS transistor M1 of said corresponding transconductance cell (102) according to said select signal, said second switch (108) being interlocked with said first switch (106).

5. The transconductance variable circuit as claimed in claim 4, wherein each of said transconductance cells (100, 102) further comprises a second MOS transistor M2 connected between said current source I_{S} and said first MOS transistor M1, for receiving a bias voltage V_{b} for tuning an output transconductance through its gate electrode.

6. A variable bandwidth filter comprising:
at least two transconductance cells (100, 102) each having a commonly connected output terminal, for generating a current which is proportional to an input signal voltage V_{IN} according to transconductances which are identically set;
an operational amplifier (112) having an inverting input terminal connected to the output terminal of said transconductance cells (100, 102);
a capacitor (C1) connected between said inverting input terminal and an output terminal of said operational amplifier (112); and
at least one select circuit (104) connected to a corresponding transconductance cell (102), for setting a frequency characteristic by selectively operating said corresponding transconductance cell (102) according to a select signal for variably selecting said frequency characteristic.

7. A variable gain amplifier comprising:
at least two transconductance cells (100, 102) each having a commonly connected output terminal, for generating a current which is proportional to an input signal voltage V_{IN} according to transconductances which are identically set;
an operational amplifier (112) having an inverting input terminal connected to the output terminal of said transconductance cells (100, 102);
a resistor (R1) connected between said inverting input terminal and an output terminal of said operational amplifier (112); and
at least one select circuit (104) connected to a corresponding transconductance cell (102), for setting a gain by selectively operating said corresponding transconductance cell (102) according to a select signal for variably selecting said gain.

8. The variable bandwidth filter as claimed in claim 6, or the variable gain amplifier as claimed in claim 7, wherein said transconductance cell (100, 102) comprises:
a current source I_{S} connected between a power terminal and said output terminal; and
a first MOS (Metal Oxide Semiconductor) transistor M1 connected between said output terminal and a ground terminal, for receiving said input signal voltage though its gate electrode.

9. The variable bandwidth filter or variable gain amplifier as claimed in claim 8, wherein said select circuit (104) comprises:
a first switch (106) for switching on or off a supply path of a current bias I_{b} to the current source I_{S} of said corresponding transconductance cell (102) according to said select signal; and
a second switch (108) for switching on or off a supply path of said input signal voltage V_{IN} to the gate electrode of said first MOS transistor M1 of said corresponding transconductance cell (102) according to said select signal, said second switch (108) being interlocked with said first switch (106).

10. The variable bandwidth filter as claimed in claim 8, wherein each of said transconductance cells (100, 102) further comprises a second MOS transistor M2 connected between said current source I_{S} and said first MOS transistor M1, for receiving a bias voltage V_{b} for tuning said frequency characteristic through its gate electrode.

11. The variable gain amplifier as claimed in claim 9, wherein each of said transconductance cells (100, 102) further comprises a second MOS transistor M2 connected between said current source I_{S} and said first MOS transistor M1, for receiving a bias voltage for tuning said gain through its gate electrode.
